(19) Europäisches Patentamt
European Patent Office
Office européen des brevets

(11) **EP 4 563 991 A1**

(12) **EUROPEAN PATENT APPLICATION**
published in accordance with Art. 153(4) EPC

(43) Date of publication:
**04.06.2025 Bulletin 2025/23**

(21) Application number: **23845921.8**

(22) Date of filing: **11.04.2023**

(51) International Patent Classification (IPC):
**G01N 24/00** (2006.01)   **G01R 33/20** (2006.01)
**G01R 33/26** (2006.01)

(52) Cooperative Patent Classification (CPC):
**G01N 24/00; G01R 33/20; G01R 33/26**

(86) International application number:
**PCT/JP2023/014755**

(87) International publication number:
**WO 2024/024181 (01.02.2024 Gazette 2024/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.07.2022 JP 2022121430**

(71) Applicants:
• **Sumida Corporation**
**Tokyo 100-0042 (JP)**
• **Kyoto University**
**Kyoto-shi, Kyoto 606-8501 (JP)**

(72) Inventors:
• **YOSHII Yoshiharu**
**Natori City, Miyagi 9811226 (JP)**
• **SAKO Akifumi**
**Natori City, Miyagi 9811226 (JP)**
• **TAKEMURA Yuki**
**Natori City, Miyagi 9811226 (JP)**
• **MIZUOCHI Norikazu**
**Kyoto-shi, Kyoto 606-8501 (JP)**

(74) Representative: **Winter, Brandl - Partnerschaft mbB**
**Alois-Steinecker-Straße 22**
**85354 Freising (DE)**

(54) **MEASUREMENT DEVICE AND MEASUREMENT METHOD**

(57) A light receiving device 13 receives fluorescence emitted by a magnetic resonance member 1 in response to an excitation light and generates a fluorescence sensor signal corresponding to a fluorescence intensity. An arithmetic processing device 31 derives a measurement value based on the fluorescence sensor signal or a detection signal that is obtained from the fluorescence sensor signal. A measurement value, which is measured when the measured field is applied to the magnetic resonance member 1, is defined as a main measurement value. A measurement value, which is measured when the measured field is not applied to the magnetic resonance member 1 and before the main measurement value is measured, is defined as a preceding measurement value. A measurement value, which is measured when the measured field is not applied to the magnetic resonance member and after the main measurement value is measured, is defined as a succeeding measurement value. The arithmetic processing device 31 respectively subtracts the preceding measurement value and the succeeding measurement value from the main measurement value at a predetermined ratio to derive the measurement value of the measured field.

EP 4 563 991 A1

$$ref1 * \alpha_{init} * (2\gamma I_{laser} + 1)/\beta$$

$$\alpha_{init} * \gamma * I_{laser}^{2}$$

**CMR_SIG**

**Fig. 1**

**Description**

TECHNICAL FIELD

The present invention relates to a measurement device and a measurement method.

BACKGROUND ART

A magnetic field measurement device performs magnetic measurement using optically detected magnetic resonance (ODMR) in which electron spin resonance of a sensing member such as a diamond structure having nitrogen and lattice defects (NV center: Nitrogen Vacancy Center) is utilized. In the ODMR, a static magnetic field is applied to a magnetic resonance member such as diamond that has the NV center in separation from a measured magnetic field, and at the same time, laser light (excitation light for initialization and measurement) and a microwave are applied in a predetermined sequence. An amount of light of fluorescence emitted from the magnetic resonance member is detected and a magnetic flux density of the measured magnetic field is derived based on the amount of light.

For instance, in Ramsey pulse sequence, (a) excitation light is irradiated to an NV center, (b) a first n/2 pulse of a microwave is applied to the NV center, (c) a second n/2 pulse of the microwave is applied to the NV center at a predetermined time interval tt from the first $\pi/2$ pulse, (d) a light emission amount from the NV center is measured by irradiating the excitation light to the NV center, and (e) a magnetic flux density is derived based on the measured light emission amount. Further, in a spin echo pulse sequence, (a) the excitation light is irradiated to the NV center, (b) the first $\pi/2$ pulse of the microwave is applied to the NV center at a phase of 0 degrees of a measured magnetic field, (c) a $\pi$ pulse of the microwave is applied to the NV center at a phase of 180 degrees of the measured magnetic field, (d) the second $\pi/2$ pulse of the microwaves is applied to the NV center at a phase of 360 degrees of the measured magnetic field, (e) the light emission amount from the NV center is measured by irradiating the excitation light to the NV center, and (f) the magnetic flux density is derived based on the measured light emission amount.

A certain sensor device measures a magnetic field by nuclear magnetic resonance using a diamond sensor including the NV center as mentioned above (for instance, refer to Patent Document 1).

PRIOR ART DOCUMENT

PATENT DOCUMENT

Patent Document 1: Japanese Patent Publication Number: 2019-138772.

SUMMARY OF THE INVENTION

PROBLEMS TO BE SOLVED BY THE INVENTION

In optically detected magnetic resonance that utilizes electron spin resonance of a sensing member, because a detection signal obtained from fluorescence is weak, it is susceptible to noise and measurement accuracy would decrease.

The present invention has been made in consideration of the above problems, and has an object that is to obtain a measurement device and a measurement method that suppress a noise component and improve measurement accuracy.

MEANS FOR SOLVING THE PROBLEMS

A measurement device according to the present invention has a magnetic resonance member, a high frequency magnetic field generator, a light emitting device, a fluorescence light receiving device, and an arithmetic processing device. Specifically, with respect to the magnetic resonance member, an electron spin quantum state changes in response to a field to be measured (a measured field) and an electron spin quantum operation can be performed by using a microwave. The high frequency magnetic field generator performs the electron spin quantum operation of the magnetic resonance member by using the microwave. The light emitting device emits excitation light to be irradiated to the magnetic resonance member. The fluorescence light receiving device receives fluorescence light emitted by the magnetic resonance member in response to the excitation light and generates a fluorescence sensor signal corresponding to an intensity of the fluorescence. The arithmetic processing device derives a measurement value based on the fluorescence sensor signal or a detection signal that is obtained from the fluorescence sensor signal. Further, a measurement value, which is measured when the measured field is applied to the magnetic resonance member, is defined as a main measurement value. A measurement value, which is measured when the measured field is not applied to the magnetic resonance member and before the main measurement value is measured, is defined as a preceding measurement value. A measurement value, which is measured when the measured field is not applied to the magnetic resonance member and after the main measurement value is measured, is defined as a succeeding measurement value. The measurement value of the measured field is derived by subtracting the preceding measurement value and the succeeding measurement value from the main measurement value in a respective predetermined ratio.

A measurement method according to the present invention includes (a) performing an electron spin quantum operation with respect to a magnetic resonance member by using a microwave according to a predetermined measurement sequence and emitting excitation light to be irradiated to the magnetic resonance member, an electron spin quantum state being changed in response to a field to be measured (a measured field) and the electron spin quantum operation being performed by using the microwave in the magnetic resonance member, and (b) receiving fluorescence light emitted by the magnetic resonance member in response to the excitation light and generating a fluorescence sensor signal corresponding to an intensity of the fluorescence, and deriving a measurement value based on the fluorescence sensor signal or a detection signal that is obtained from the fluorescence sensor signal. Further, a measurement value, which is measured when the measured field is applied to the magnetic resonance member, is defined as a main measurement value. A measurement value, which is measured when the measured field is not applied to the magnetic resonance member and before the main measurement value is measured, is defined as a preceding measurement value. A measurement value, which is measured when the measured field is not applied to the magnetic resonance member and after the main measurement value is measured, is defined as a succeeding measurement value. The measurement value of the measured field is derived by subtracting the preceding measurement value and the succeeding measurement value from the main measurement value in a respective predetermined ratio.

EFFECTS OF THE INVENTION

According to the present invention, it is possible to obtain a measurement device and a measurement method that suppress a noise component and improve measurement accuracy.

BRIEF DESCRIPTION OF THE DRAWINGS

[Fig. 1] Fig. 1 is a block diagram that shows a configuration of a measurement device according to a first embodiment of the present invention.
[Fig. 2] Fig. 2 is a diagram that explains nonlinearity of a level of a fluorescence sensor signal with respect to an amount of excitation light.
[Fig. 3] Fig. 3 is a diagram that shows an example of a measurement sequence.
[Fig. 4] Fig. 4 is a diagram that explains reference light sensor signals refl(t) and ref2(t), a fluorescence sensor signal PL(t), and a CMR signal CMR_SIG(t).
[Fig. 5] Fig. 5 is a diagram that shows an example of a window function.
[Fig. 6] Fig. 6 is a diagram that shows a frequency characteristic of the window function shown in Fig. 5.
[Fig. 7] Fig. 7 is a flow diagram that explains an operation of the measurement device according to the first embodiment.
[Fig. 8] Fig. 8 is a flow diagram that explains an acquisition of a measurement value.
[Fig. 9] Fig. 9 is a block diagram that shows a configuration of a measurement device according to a second embodiment of the present invention.
[Fig. 10] Fig. 10 is a diagram that shows an example of a fluorescence sensor signal and a window function.
[Fig. 11] Fig. 11 is a diagram that explains continuous measurement of a measured field according to a third embodiment.

EMBODIMENTS FOR CARRYING OUT THE INVENTION

Embodiments according to the present invention will be explained below with reference to the drawings.

FIRST EMBODIMENT

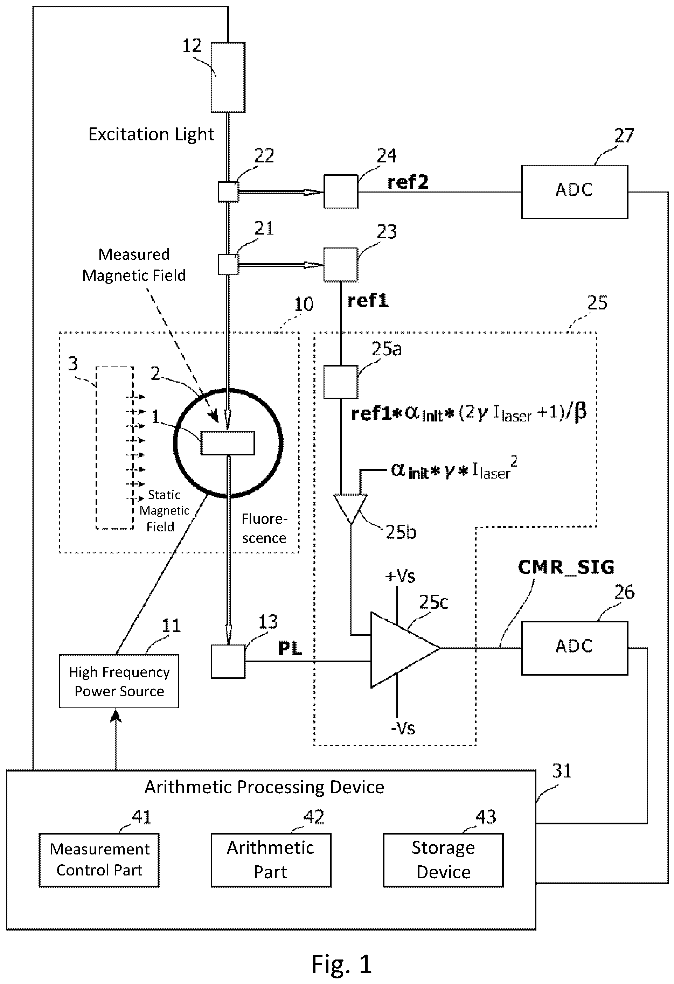

Fig. 1 is a block diagram that shows a configuration of a measurement device according to a first embodiment of the present invention. The measurement device shown in Fig. 1 has a sensor part 10, a high frequency power source 11, a light emitting device 12, and a light receiving device 13.

The sensor part 10 detects a field to be measured (a measured field, for instance, a magnetic field such as an intensity and a direction of the magnetic field) at a predetermined position (for instance, on or above a surface of an object to be inspected). Further, the field to be measured (the measured field) may be an alternating current field with a single frequency, an alternating current field with a predetermined cycle having a plurality of frequency components, or a direct current field.

In this embodiment, the sensor part 10 has a magnetic resonance member 1, a high frequency magnetic field generator 2, and a magnet 3, and detects the measured field by using the ODMR.

The magnetic resonance member 1 has a crystal structure. An electron spin quantum state of the magnetic resonance member 1 changes in correspond with the measured field (here, a magnetic field), and at the same time, the magnetic resonance member 1 is a member in which it is capable of an electron spin quantum operation by a microwave at a frequency that corresponds to an arrangement direction of defects and impurities in a crystal lattice (based on Rabi oscillation). That is, the magnetic resonance member 1 is placed at the position where a magnetic field is measured.

In this embodiment, the magnetic resonance member 1 is an optically detected magnetic resonance member having a plurality (that is, an ensemble) of specific color centers. This specific color center has an energy level capable of Zeeman splitting, and at the same time, can take a plurality of directions in which shift widths of the energy level at the time of Zeeman splitting are different from each other.

Here, the magnetic resonance member 1 is a member such as a diamond that includes a plurality of NV (Nitrogen Vacancy) centers as a specific color center of a single category (or type). In the case of the NV center, a ground state is a triplet state of $ms = 0, +1$, and $-1$ and a level of $ms = +1$ and a level of $ms = -1$ undergo Zeeman splitting. When the NV center transitions from an excited state at the levels of $ms = +1$ and $ms = -1$ to the ground state, the NV center is accompanied by fluorescence at a predetermined proportion and the remaining proportion of the NV center transitions from the excited state ($ms = +1$ or $ms = -1$) to the ground state ($ms = 0$) with non-radiation.

Note that the color center included in the magnetic resonance member 1 may be a color center other than the NV center.

The high frequency magnetic field generator 2 applies a microwave to the magnetic resonance member 1 so as to perform an electron spin quantum operation of the magnetic resonance member 1. For instance, the high frequency magnetic field generator 2 is a plate-shaped coil and has a substantially circular coil part that emits the microwave and terminal parts that extend from both ends of the coil part and are fixed to a substrate. The high frequency power source 11 generates a current of the microwave and is conductively connected to the high frequency magnetic field generator 2. The coil part conducts two currents that are mutually in parallel at a predetermined interval so as to sandwich the magnetic resonance member 1 at both end surface parts of the coil part and emit the above-mentioned microwave. Here, the coil part is a plate-shaped coil, however, because the current of the microwave flows through the end surface part of the coil part due to a skin effect, two currents are formed. As a result, the microwave with a spatially uniform intensity is applied to the magnetic resonance member 1.

In the case of the NV center, since the color center is formed by a defect (vacancy) (V) and nitrogen (N) as an impurity in the diamond crystal, there are four possible positions for adjacent nitrogen (N) with respect to the defect (vacancy) (V) in the diamond crystal (that is, the arrangement directions of a pair of the vacancy and the nitrogen). Sublevels (that is, the energy level from the ground) after Zeeman splitting respectively corresponding to these arrangement directions are different from each other. Therefore, in a characteristic of a fluorescence intensity after Zeeman splitting due to a static magnetic field with respect to a frequency of the microwave, in correspond with each direction i ($i = 1, 2, 3, 4$), four pairs of dip frequencies ($fi+, fi-$) that are different from one another appear. Here, the above-mentioned frequency of the microwave (wavelength) is set in correspond with any of the dip frequencies of these four pairs of dip frequencies.

Further, the magnet 3 applies a static magnetic field (a DC magnetic field) to the magnetic resonance member 1 so that the energy levels of a plurality of specific color centers (here, a plurality of NV centers) in the magnetic resonance member 1 undergo Zeeman splitting. Here, the magnet 3 is a ring-type permanent magnet, such as a ferrite magnet, an alnico magnet, or a samarium cobalt magnet.

In this embodiment, because an application direction of the above-mentioned static magnetic field is the same as an application direction of the above-mentioned measured magnetic field, by applying the above-mentioned static magnetic field, the change of the fluorescence intensity at the above-mentioned dip frequency is enhanced and the sensitivity is increased.

Further, in this embodiment, the magnetic resonance member 1 is provided with the plurality of color centers (here, the NV centers) in which it is capable of the electron spin quantum operation by the above-mentioned microwaves. The magnet 3 applies the substantially uniform static magnetic field to a predetermined region (an irradiation region of the excitation light) of the magnetic resonance member 1. For instance, the static magnetic field is applied as a difference or a ratio between the maximum value and the minimum value of the intensities of the static magnetic field in the predetermined region is equal to or less than a predetermined value.

Further, in the magnetic resonance member 1, as the arrangement direction of the above-mentioned defects and impurities is substantially coincident with the above-mentioned direction of the static magnetic field (and the direction of the applied magnetic field), the crystal of the magnetic resonance member 1 is formed and the direction of the magnetic resonance member 1 is set.

Furthermore, in this embodiment, in order to irradiate the magnetic resonance member 1 with excitation light, an optical system from the light emitting device 12 to the magnetic resonance member 1 is provided. Further, in order to detect fluorescence from the magnetic resonance member 1, an optical system from the magnetic resonance member 1 to the light receiving device 13 is provided.

The light emitting device 12 has, such as a laser diode, as a light source and the light source emits laser light having a predetermined wavelength as the excitation light to irradiate the magnetic resonance member 1. Further, the light receiving device 13 has, such as a photodiode or a phototransistor, as a light receiving element, receives the fluorescence emitted by the magnetic resonance member 1 in correspond with the excitation light, and generates a fluorescence sensor signal PL corresponding to the intensity of the fluorescence. This fluorescence is concentrated toward the light receiving device 13 by an optical system such as a compound parabolic concentrator (CPC).

Further, the measurement principle will be explained.

As expressed in the following equation, an intensity I of the excitation light mentioned above is the sum of an original intensity $I_{laser}$ and a noise component intensity (an intensity of noise) $I_{noise}$. Note that this noise component is generated due to, for instance, fluctuation in a power supply voltage of the light emitting device 12 and fluctuation in a light emission amount from the light source, and has a frequency in a range of, for instance, about kHz order to about 100 kHz order.

$$I = I_{laser} + I_{noise}$$

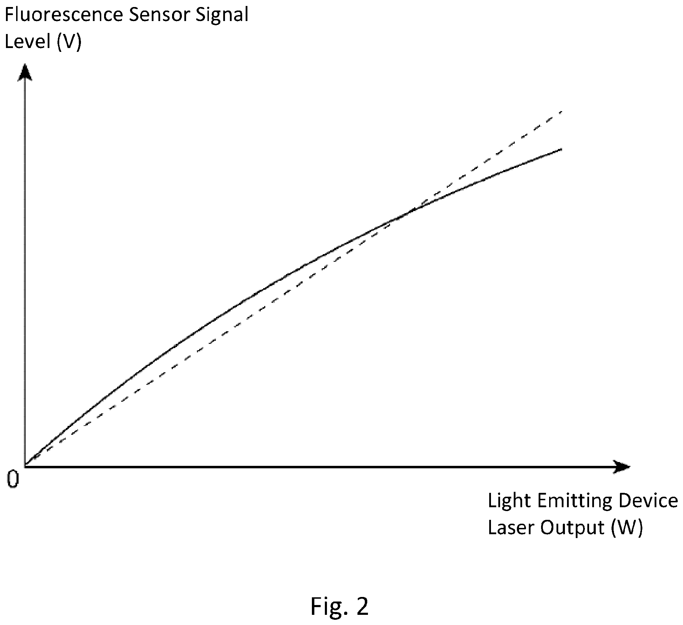

Further, a level of the fluorescence sensor signal PL basically is raised as the intensity I of the excitation light increases. However, due to the change in the electron spin quantum state with respect to the measured field, the fluorescence intensity at the start of the excitation light irradiation during the measurement becomes low. Thereafter, until the influence of the change in the electron spin quantum state with respect to the measured field disappears, the fluorescence intensity gradually increases. Therefore, a detection signal that is proportional to a level variation $\alpha_{cont}(t)$ of the fluorescence sensor signal PL due to the change in the electron spin quantum state with respect to the measured field is derived as a signal indicating the measured field. The fluorescence sensor signal PL is expressed by the following equation. Here, because the fluorescence intensity is relatively low, the level of the fluorescence sensor signal PL has nonlinearity. Fig. 2 is a diagram that explains the nonlinearity of the level of the fluorescence sensor signal with respect to an amount of the excitation light. For instance, as shown in Fig. 2, the inclination of the level of the fluorescence sensor signal PL is large (increases) as the fluorescence intensity is small (decreases).

$$PL(t) = \alpha(t) \times f(I) = (\alpha_{init} + \alpha_{cont}(t)) \times I = (\alpha_{init} + \alpha_{cont}(t)) \times f(I_{laser} + I_{noise}).$$

Further, $\alpha_{init}$ is a coefficient indicating a portion (a portion that is not affected by changes in the electron spin quantum state with respect to the measured field) being proportional to the intensity I of the excitation light, and f is a function that shows the nonlinearity with respect to the intensity I of the excitation light. For instance, f is a polynomial expression of degree N (N $\geqq$ 2), and in this embodiment, f is a quadratic expression (f(x) = x + $\gamma \cdot$ x$^2$, $\gamma$ is a constant). The fluorescence sensor signal PL in this case is expressed by the following equation.

Note that the function f and the constant $\gamma$ are derived in advance by, such as experiments, on a sensor of the light receiving device 13. Further, this function f may have another function form such as an exponential function.

$$PL(t) = \alpha(t) \times f(I) = (\alpha_{init} + \alpha_{cont}(t)) \times I = (\alpha_{init} + \alpha_{cont}(t)) \times \{(I_{laser} + I_{noise}) + \gamma (I_{laser} + I_{noise})^2\} = \alpha_{init} \{(\gamma I_{laser}^2 + I_{laser}) + (2\gamma I_{laser} + 1) I_{noise} + \gamma I_{noise}^2\} + \alpha_{cont}(t) \{(I_{laser} + I_{noise}) + \gamma (I_{laser} + I_{noise})^2\}.$$

On the other hand, because a level ref of a reference light sensor signal of reference light being branched from the excitation light is proportional to the intensity I of the excitation light, it is expressed as the following equation. Further, because the intensity of the reference light is relatively high, the level of the reference light sensor signal PL is linear (proportional) with reference to the intensity of the reference light.

$$ref = ref1 = ref2 = \beta \times I = \beta \times (I_{laser} + I_{noise}).$$

Where, $\beta$ is a constant. Note that ref1 and ref2 will be explained later.

Specifically, PL is expressed by the above equation by ignoring a cubic term and subsequent terms because of $I_{noise} \ll I_{laser}$ after Taylor expansion is performed with respect to PL. In addition, as shown below, a CMR signal CMR_SIG(t) is derived from the PL and the ref by subjecting the above PL and the ref to Taylor expansion (Maclaurin

expansion) using $I_{noise}$ and approximating them while ignoring the cubic term and the subsequent terms. Note that in the following equation, PL $(I_{laser} + I_{noise})$ indicates that the PL is a function of $(I_{laser} + I_{noise})$, and PL $(I_{laser})$ is the PL when $I_{noise}$ is set to 0. Similarly, ref $(I_{laser} + I_{noise})$ indicates that the ref is a function of $(I_{laser} + I_{noise})$, and ref $(I_{laser})$ is the ref when $I_{noise}$ is set to 0. Further, PL' is a primary differential coefficient of the PL with respect to $I_{noise}$ when $I_{noise} = 0$, and ref' is a primary differential coefficient of the ref with respect to $I_{noise}$ when $I_{noise} = 0$.

PL $(I_{laser} + I_{noise})$ = PL $(I_{laser})$ + PL' $(I_{laser})$ $I_{noise}$ + ....

ref $(I_{laser} + I_{noise})$ = ref $(I_{laser})$ + ref' $(I_{laser})$ $I_{noise}$ + ....

Further, because of $I_{noise} \ll I_{laser}$, the cubic term and the subsequent terms of $I_{noise}$ can be ignored. Therefore, the above PL and ref are approximated by the following equations.

$$[0053] \quad PL\ (I_{laser} + I_{noise}) = PL\ (I_{laser}) + PL'\ (I_{laser})\ I_{noise}.$$

ref $(I_{laser} + I_{noise})$ = ref $(I_{laser})$ + ref' $(I_{laser})$ $I_{noise}$.

Further, common mode rejection is performed on PL(t) so as to generate the CMR signal. Specifically, the CMR signal CMR_SIG(t) is derived by the following equation so that the influence of $I_{noise}$ on $\alpha_{init}$ is removed.

CMR_SIG(t) = PL - (PL' $(I_{laser})$ / ref' $(I_{laser})$) ref .

Note that, because of PL' $(I_{laser})$ / ref' $(I_{laser})$ = $\alpha_{init}$ $(2\gamma I_{laser} + 1)$ / $\beta$, the CMR signal CMR_SIG(t) is expressed by the following equation. Further, in the following equation, a constant $\alpha_{init}\gamma I_{laser}^2$ is added in order to remove a term (explained below) that is a constant regardless of time t.

CMR_SIG(t) = PL(t) - $\alpha_{init}$ $(2\gamma I_{laser} + 1)$ / $\beta$ × ref (t) + $\alpha_{init}\gamma I_{laser}^2$ = $\alpha_{cont}$ (t) $\{(I_{laser} + I_{noise}) + \gamma\ (I_{laser} + I_{noise})^2\}$.

With respect to $\alpha_{init} \{(I_{laser} + I_{noise}) + \gamma\ (I_{laser} + I_{noise})^2\}$ in PL(t), since the sufficiently small term $\gamma I_{noise}^2$ is ignored, $\alpha_{init} \{(I_{laser} + I_{noise}) + \gamma\ (I_{laser} + I_{noise})^2\} = \alpha_{init}\ (\gamma I_{laser} + 1)\ I_{laser} + \alpha_{init}\ (2\gamma I_{laser} + 1)\ I_{noise} = \alpha_{init}\ (2\gamma I_{laser} + 1)$ × $(I_{laser} + I_{noise})$ - $\alpha_{init}\gamma I_{laser}$ is obtained.

Further, a level variation component signal SD(t) is derived as shown in the following equation. As a result, the influence of $I_{noise}$ on $\alpha_{cont}$(t) is removed.

SD(t) = $\alpha_{cont}$(t) = CMR_SIG(t) / (ref (t) + $\gamma$ · ref(t)$^2$).

The above-mentioned CMR signal CMR_SIG(t) or the level variation component signal SD(t) is derived as a detection signal (a signal indicating the measured field), and such as a peak value (a value at t = 0), a time integration value, and a difference in an integrated value explained below of the detection signal are correlated with an intensity of the measured field. Therefore, the intensity of the measured field is derived from such as the peak value, the time integration value, and the difference in the integrated value explained below of the detection signal by specifying a correspondence relation between the peak value, the time integration value, and the difference in the integrated value explained below of the detection signal and the intensity of the measured field by such as experiments in advance and using a calculation equation or a table that shows the correspondence relation.

Based on such the measurement principle, the following configuration is provided.

The measurement device shown in Fig. 1 further has light separation parts 21 and 22 as optical elements on an optical path of the excitation light from the light emitting device 12 to the magnetic resonance member 1. The light separation parts 21 and 22 respectively branch a part of the excitation light from the excitation light and emit the part of the excitation light in a different direction as the reference light. For instance, the light separation parts 21 and 22 are deflection independent beam splitters.

Further, the measurement device shown in Fig. 1 has light receiving devices 23 and 24 that receive the reference lights and generate reference light sensor signals ref1 and ref2 (the ref(s) mentioned above) corresponding to the intensities of the reference lights.

In this embodiment, two reference lights are separately generated from the excitation light, and two reference light sensor signals ref1 and ref2 are generated. The reference light sensor signal ref1 is used for the common mode rejection, which will be explained below. The reference light sensor signal ref2 is digitized and used to generate the detection signal SD.

Furthermore, the measurement device shown in Fig. 1 has a CMR arithmetic part 25 as an analog calculation circuit. The CMR arithmetic part 25 performs the common mode rejection with respect to the fluorescence sensor signal PL based on the reference light sensor signal ref1 and generates the CMR signal CMR_SIG based on the common mode rejection. Specifically, the CMR arithmetic part 25 has a coefficient part 25a, an offset eliminating part 25b, and a differential amplifier 25c. The coefficient part 25a multiplies the reference light sensor signal ref1 by a predetermined coefficient $\alpha_{init}$ $(2\gamma I_{laser} + 1) / \beta$. The offset eliminating part 25b subtracts the constant $\alpha_{init}\gamma I_{laser}^2$ indicating the above-mentioned offset from an output signal ref1 $\times$ $\alpha_{init}$ $(2\gamma I_{laser} + 1) / \beta$ of the coefficient part 25a. The differential amplifier 25c calculates a difference between the fluorescence sensor signal PL and an output signal ref1 $\times$ $\alpha_{init}$ $(2\gamma I_{laser} + 1) / \beta - \alpha_{init}\gamma I_{laser}^2$ of the offset eliminating part 25b, and outputs the calculation result as the CMR signal CMR_SIG. In addition, in FIG. 1, the offset eliminating part 25b subtracts the constant $\alpha_{init}\gamma I_{laser}^2$ indicating the above-mentioned offset from the output signal ref1 $\times$ $\alpha_{init}$ $(2\gamma I_{laser} + 1) / \beta$ of the coefficient part 25a. However, instead of the above, the constant $\alpha_{init}\gamma I_{laser}^2$ indicating the above-mentioned offset may be added to the fluorescence sensor signal PL, or the constant $\alpha_{init}\gamma I_{laser}^2$ indicating the above-mentioned offset may be added to the output signal of the differential amplifier 25c.

Note that the coefficient part 25a as the analog calculation circuit may be provided. Alternatively, without providing the coefficient part 25a, the reference light sensor signal, which is obtained by adjusting a gain of the light receiving device 23 and multiplying by the predetermined coefficient $\alpha_{init}$ $(2\gamma I_{laser} + 1) / \beta$, may also be possible to output.

Furthermore, the measurement device shown in Fig. 1 has analog/digital converters 26 and 27 that respectively digitize the CMR signal CMR_SIG and the reference sensor signal ref2 and has an arithmetic processing device 31 that controls the measurement device and performs signal processing.

The analog/digital converters 26 and 27 respectively digitize the CMR signal CMR_SIG and the reference sensor signal ref2 with a predetermined number of bits and a predetermined sampling period (speed), and output the digitized CMR signal CMR_SIG and the digitized reference sensor signal ref2 to the arithmetic processing device 31.

The arithmetic processing device 31 has, for instance, a computer, executes a signal processing program by the computer, and operates as various processing units. In this embodiment, the arithmetic processing device 31 causes the computer to operate as a measurement control part 41 and an arithmetic part 42, and also has a nonvolatile storage device 43.

The signal processing program is stored in the storage device 43. The computer is equipped with, for instance, a CPU (Central Processing Unit), a ROM (Read Only Memory), and a RAM (Random Access Memory), and operates as the measurement control part 41 and the arithmetic part 42 by loading the signal processing program into the RAM and executing the signal processing program by the CPU.

According to a predetermined measurement sequence, the measurement control part 41 (a) controls the high frequency power supply 11 and the light emitting device 12 and (b) obtains the digitized CMR signal CMR_SIG and the digitized reference light sensor signal ref2 as mentioned above, stores them in the RAM or the storage device 43, and causes the arithmetic unit 42 to derive a measurement value of the measured field.

This measurement sequence is set according to such as a frequency of the measured field. For instance, when the measured field is an alternating current field with a relatively high frequency, a spin echo pulse sequence (such as a Hahn echo sequence) is applied as this measurement sequence. However, the measurement sequence is not limited to the above configuration. Further, for instance, when the measured field is an alternating current field with a relatively low frequency, a physical field can be measured several times in one period (cycle) of the measured field by using a Ramsey pulse sequence (that is, a measurement sequence for a direct current field) so that the measured field (an intensity, a waveform, and so on) may be specified based on these measurement results.

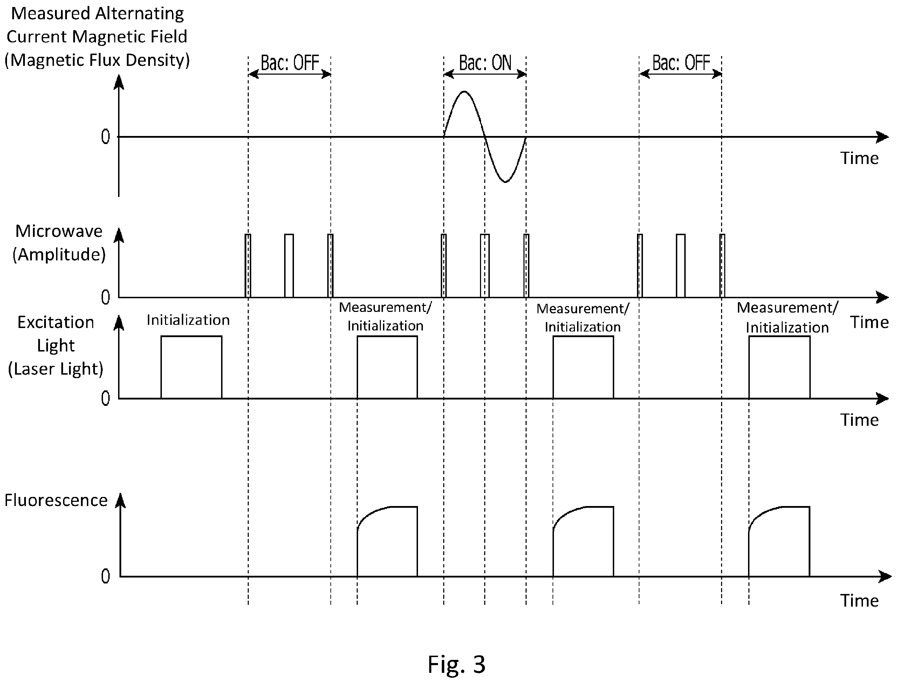

Fig. 3 is a diagram that shows an example of a measurement sequence. Fig. 3 shows the timing of a microwave pulse and the irradiation timing of the excitation light (twice for initialization and measurement) with respect to the measured magnetic field in the case of a spin echo pulse sequence. As shown in Fig. 3, for each measurement, fluorescence is detected during the irradiation period of the excitation light.

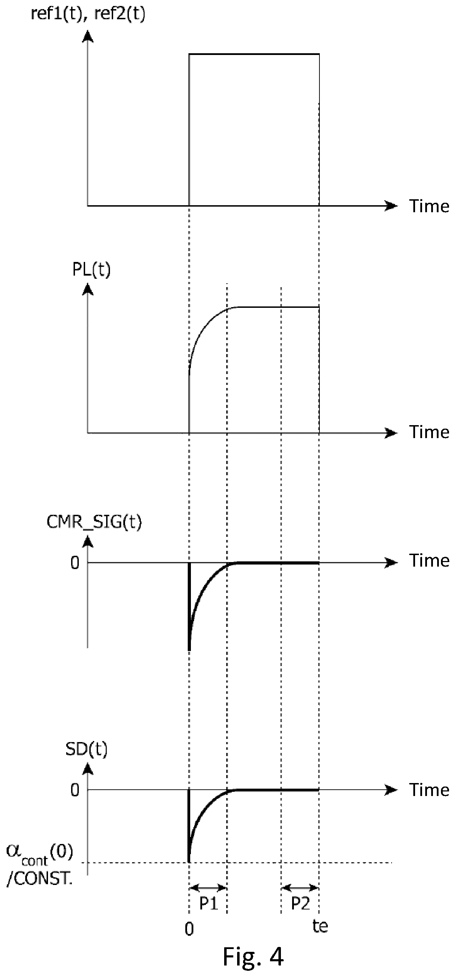

Fig. 4 is a diagram that explains reference light sensor signals refl(t) and ref2(t), a fluorescence sensor signal PL(t), and a CMR signal CMR_SIG(t).

As shown in Fig. 4, the reference light sensor signals refl(t) and ref2(t) are substantially rectangular pulse signals during the irradiation period. The fluorescence sensor signal PL(t) becomes a pulse signal that gradually rises and converges to a constant level during the irradiation period. Further, the CMR signal CMR_SIG(t) is obtained by the common mode rejection.

Here, as mentioned above, the arithmetic part 42 calculates and generates the level variation component signal SD(t), which is proportional to $\alpha_{cont}(t)$, from the digitized CMR signal CMR_SIG(t) and the digitized reference light sensor signal ref2(t) and derives the measurement value (that is, for instance, a magnetic flux density or a waveform of the magnetic field) of the measured field based on the signal SD(t). Alternatively, as mentioned above, the arithmetic part 42 may use the digitized CMR signal CMR_SIG(t) as a detection signal and derive a measurement value of the measured field based on the detection signal (the CMR signal).

Specifically, a measurement value, which is measured when the measured field is applied to the magnetic resonance member 1, is defined as a main measurement value. A measurement value, which is measured when the measured field is not applied to the magnetic resonance member 1 and before the main measurement value is measured, is defined as a preceding measurement value. A measurement value, which is measured when the measured field is not applied to the magnetic resonance member 1 and after the main measurement value is measured, is defined as a succeeding measurement value. The arithmetic part 42 respectively subtracts the preceding measurement value and the succeeding measurement value from the main measurement value at a predetermined ratio so as to derive the measurement value of the measured field. In other words, the main measurement value, the preceding measurement value, and the succeeding measurement value are obtained by using the same measurement method. The main measurement value is corrected by using the preceding measurement value and the succeeding measurement value. Further, the corrected main measurement value is used as the measurement value of the measured field at that time.

For instance, weighting coefficients of a preceding measurement value Sa, a main measurement value So, and a succeeding measurement value Sb are set to - 0.5, +1.0, and -0.5. A sum of values, which are obtained by respectively multiplying the preceding measurement value, the main measurement value, and the succeeding measurement by the weighting coefficients, is set to a measurement value S ($S = -0.5 \times Sa + So - 0.5 \times Sb$) of the measured field. Here, the weighting coefficients of the preceding measurement value Sa and the succeeding measurement value Sb are the same each other. Note that this ratio may be other ratios as long as the positive and negative signs are reversed between the weighting coefficients of the preceding and succeeding measurement values and the weighting coefficient of the main measurement value, and at the same time, the sum of the weighting coefficients of the preceding measurement value, the main measurement value, and the succeeding measurement value is zero.

Further, in the first embodiment, the arithmetic part 42 applies a predetermined window function to the detection signal (CMR_SIG(t) or SD(t)), and derives each measurement value (the preceding measurement value, the main measurement value, and the succeeding measurement value) based on the fluorescence sensor signal PL(t) or the detection signal (CMR_SIG(t) or SD(t)) to which the window function has been applied.

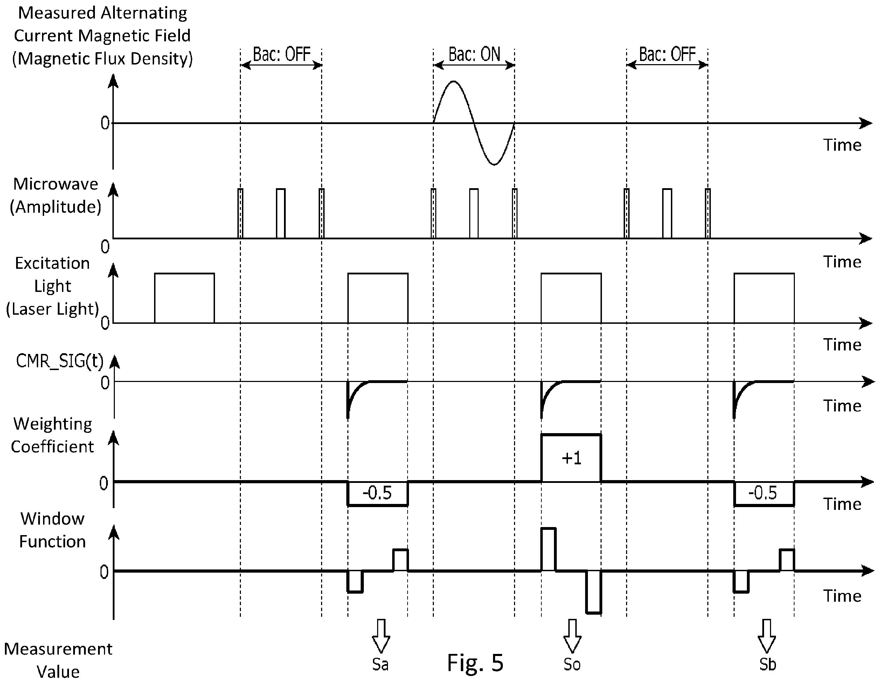

Fig. 5 is a diagram that shows an example of a window function. As shown in Fig. 5, the above-mentioned window function is expressed as waveforms in which the positive and negative signs are reversed between a period P1 and a period P2 and the absolute values of the waveforms are the same. Here, the window function is used to derive a difference in the integrated value of the detection signal (CMR_SIG(t) or SD(t)) between a first period P1 in the first half (a former part) and a second period P2 in the second half (a latter part) of the irradiation period of the excitation light.

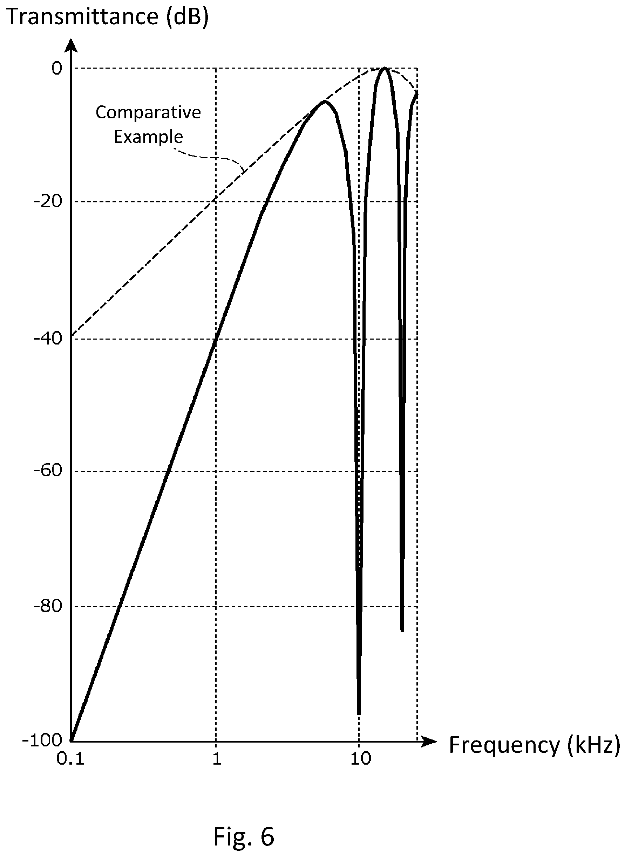

Further, Fig. 6 is a diagram that shows a frequency characteristic of the window function shown in Fig. 5. When the detection signal is a CMR signal, the arithmetic part 42 (a) respectively integrates (adds up) values of the digitized CMR signals that are obtained a same plurality of times (a predetermined number of samplings, for instance, 1,000 times) each other during each of the period P1 in the first half and the period P2 in the second half of the irradiation period of the excitation light, and (b) calculates a difference between an integrated value (a total sum or an average) of the CMR signals with respect to the period P1 and an integrated value (a total sum or an average) of the CMR signals with respect to the period P2 so as to remove the noise components in the CMR signals. For instance, as shown in Fig. 4, the period P1 in the first half is a period of a predetermined length of time from the start time of the irradiation (t = 0), and the period P2 in the second half is a period of a predetermined length of time until the end time of the irradiation (t = te). Here, the lengths of time of the P1 and the P2 are the same. Thereafter, the integrated value of the second half is subtracted from the integrated value of the first half and a value of the subtraction result is obtained. By setting the obtained value of the subtraction result as a value of the CMR signal, to which the window function has been applied, the noise component in the CMR signal (highfrequency noise components such as those of approximately 10 kHz or higher) is suppressed. Further, a case in which the detection signal is an SD signal is in the same manner.

In this embodiment, as shown in, for instance, Fig. 5, when the preceding measurement value and the succeeding measurement value are measured, the arithmetic part 42 respectively derives the preceding measurement value and the succeeding measurement value by applying the window function respectively multiplied by the weighting coefficients of the preceding measurement value and the succeeding measurement value corresponding to the ratio. Further, the arithmetic part 42 substantially and respectively subtracts the preceding measurement value and the succeeding measurement value from the main measurement value at the above-mentioned ratio, thereby the measurement value of the measured field is derived from the main measurement value, and the preceding measurement value and the succeeding measurement value.

Furthermore, as shown in Fig. 5, when the weighting coefficients of the preceding measurement value, the main measurement value, and the succeeding measurement value are set to -0.5, +1.0, and -0.5, the frequency characteristics of a series of the window functions become, for instance, frequency characteristics shown in Fig. 6, and the noise components being equal to or less than a few kHz (such as 1/f noise) are suppressed. Note that the broken line (the comparative example) in Fig. 6 shows frequency characteristics when the preceding measurement value and the succeeding measurement value are not applied. When the preceding measurement value and the succeeding measurement value are applied, an attenuation rate of the noise components being equal to or less than a few kHz (such as the 1/f noise) is greater than the case in which the preceding measurement value and the succeeding measurement value are not applied.

Further, in this embodiment, the analog/digital converter 26 operates faster than the analog/digital converter 27. The analog/digital converter 27 performs a digitizing operation with higher precision than the analog/digital converter 26.

For instance, the analog/digital converter 26 converts an input analog signal into a 20-bit digital signal at, for instance, 200M samples/sec. Further, the analog/digital converter 27 converts an input analog signal into a 24-bit digital signal at, for instance, 100k samples/sec.

Further, because the CMR signal that is converted from analog to digital by the analog/digital converter 26 changes relatively quickly, the CMR signal is sampled by the high-speed analog/digital converter 26, and as mentioned above, the noise removal based on a plurality of samples (samplings) is performed. On the other hand, as mentioned above, the reference light sensor signal ref2 that is converted from analog to digital by the analog/digital converter 27 is used for the calculation in order to theoretically remove the influence of the noise component $I_{noise}$ of the excitation light in the CMR signal. Thus, it is necessary to perform the calculation with accuracy according to a relative voltage level with respect to the voltage level of the fluorescence sensor signal PL of the term of the product of the level variation $\alpha_{cont}(t)$ in the detected fluorescence sensor signal PL and the noise component intensity $I_{noise}$. Therefore, the reference light sensor signal ref2 is sampled by the analog/digital converter 27 having relatively high precision.

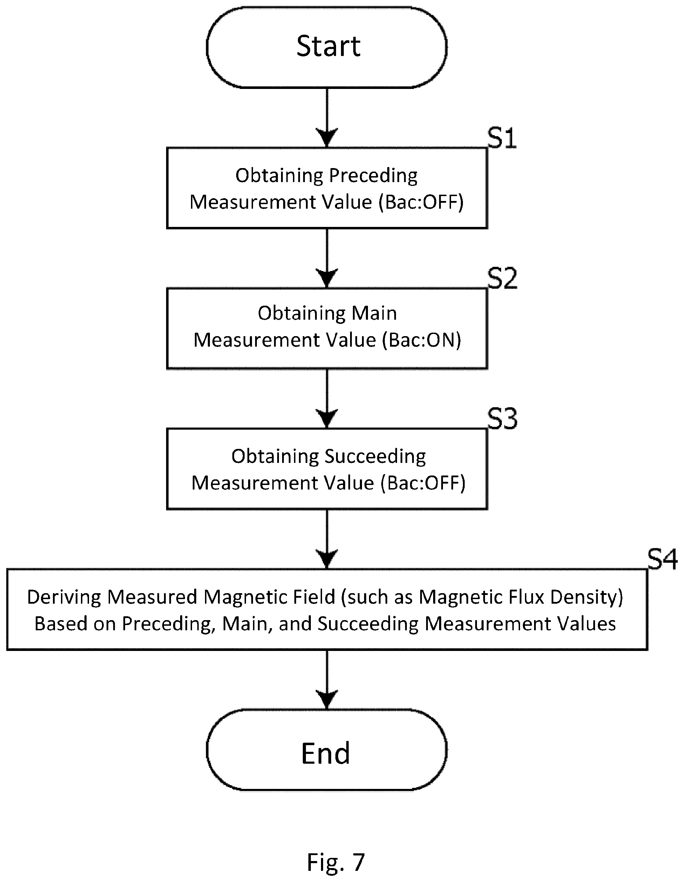

Next, an operation of the measurement device according to the embodiment will be explained. Fig. 7 is a flow diagram that explains the operation (that is, a measurement method) of the measurement device according to the first embodiment.

The sensor part 10 is arranged at a measurement position of the measured field (here, an alternating current magnetic field Bac). Note that measurements may be respectively performed at a plurality of measurement positions while scanning the sensor part 10.

Thereafter, first, the measurement control part 41 performs measurement in a state in which the measured field is turned off (that is, the state in which the measured field is not applied to the magnetic resonance member 1) and obtains a preceding measurement value (step S1).

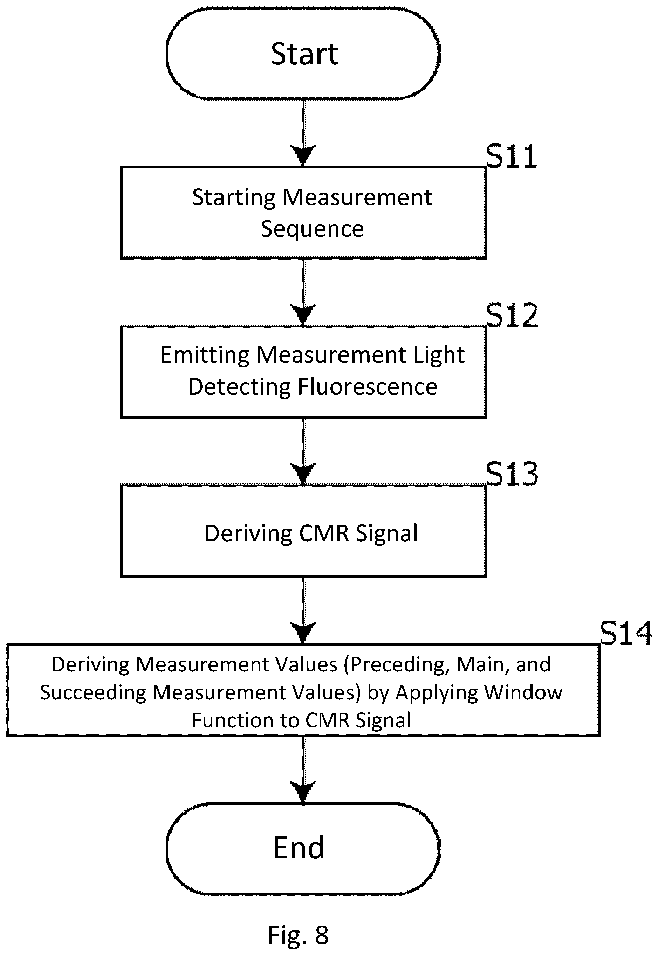

Further, an acquisition of measurement values will be explained. Fig. 8 is a flow diagram that explains the acquisition of measurement values.

The measurement control part 41 causes the light emitting device 12 to emit the excitation light and causes the high frequency magnetic field generator 2 to transmit a microwave according to a predetermined measurement sequence (step S11).

As a result, during the irradiation period of the excitation light at the time of measurement, the light receiving device 13 outputs the fluorescence sensor signal PL (an analog signal), and the light receiving devices 23 and 24 respectively output the reference light sensor signals ref1 and ref2 (analog signals) (step S12). Thereafter, the CMR arithmetic part 25 outputs the CMR signal CMR_SIG(t) based on the fluorescence sensor signal PL(t) and the reference light sensor signal ref1. Further, the CMR signal CMR_SIG(t) is digitized by the analog/digital converter 26 (step S13).

When the measurement control part 41 obtains this CMR signal CMR_SIG(t) (a digital signal), the arithmetic part 42 applies the above-mentioned window function to the CMR signal, derives the integrated value of the CMR signal (for instance, the difference between the integrated value in the above-mentioned period P1 and the integrated value in the above-mentioned period P2) after the window function is applied as the above-mentioned measurement value, and stores it in a memory (not shown) (step S14).

In this manner, the measurement value (here, the preceding measurement value, however, the same applies to the main measurement values and the succeeding measurement values) is obtained. Further, when SD(t) is used as the detection signal, SD(t) is derived based on the reference light sensor signal ref2 and the CMR signal as mentioned above. Further, the above-mentioned window function is applied to SD(t), and the integrated value of SD(t), to which the window function is applied, is derived as the above-mentioned measurement value.

Next, the measurement control part 41 performs the above-mentioned measurement in a state in which the measured field is turned on (that is, the state in which the measured field is applied to the magnetic resonance member 1) and obtains the main measurement value (step S2).

Thereafter, the measurement control part 41 performs the above-mentioned measurement in a state in which the measured field is turned off, and obtains the succeeding measurement value (step S3).

Further, after the succeeding measurement value is obtained, the arithmetic part 42 derives the measurement value of the measured field based on the main measurement value, and the preceding measurement value and the succeeding measurement value that are immediately before and after the main measurement value (step S4). Specifically, because the measured field is not applied to the magnetic resonance member 1, the preceding measurement value and the succeeding measurement value indicate the noise components (such as 1/f noise) originating from the measurement system. Therefore, by subtracting the preceding measurement value and the succeeding measurement value from the main measurement value at a specific ratio, these noise components in the main measurement value are suppressed.

As mentioned above, according to the first embodiment, the high frequency magnetic field generator 2 performs the electron spin quantum operation with respect to the magnetic resonance member 1 using the microwave. In the magnetic resonance member 1, the electron spin quantum state changes in correspond with the measured field and the electron spin quantum operation can be performed by using the microwave. The light emitting device 12 emits the excitation light to irradiate the magnetic resonance member 1. The light receiving device 13 receives the fluorescence that is emitted by the magnetic resonance member 1 in correspond with the excitation light and generates the fluorescence sensor signal corresponding to the intensity of the fluorescence. The arithmetic processing device 31 derives the measurement value based on the detection signal that is obtained from the fluorescence sensor signal. The measurement value, which is measured when the measured field is applied to the magnetic resonance member 1, is defined as the main measurement value. The measurement value, which is measured when the measured field is not applied to the magnetic resonance member 1 and before the main measurement value is measured, is defined as the preceding measurement value. The measurement value, which is measured when the measured field is not applied to the magnetic resonance member and after the main measurement value is measured, is defined as the succeeding measurement value. The arithmetic processing device 31 respectively subtracts the preceding measurement value and the succeeding measurement value from the main measurement value at a predetermined ratio so as to derive the measurement value of the measured field.

As a result, because the preceding measurement value and the succeeding measurement value are derived as the measurement values of the noise components corresponding to both immediately before and after the main measurement value, and the main measurement value is corrected by using the preceding measurement value and the succeeding measurement value, the measurement accuracy is improved by suppressing the noise components.

SECOND EMBODIMENT

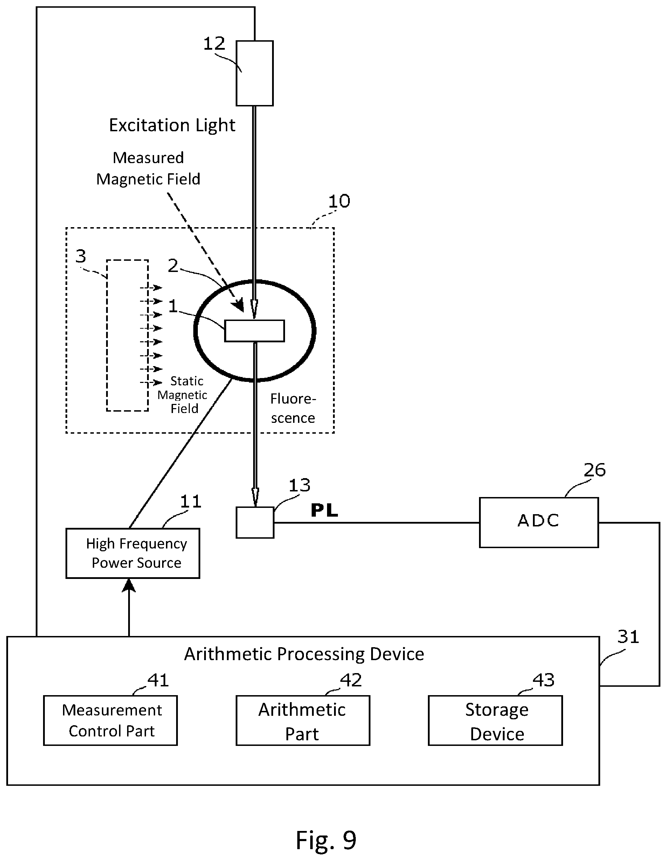

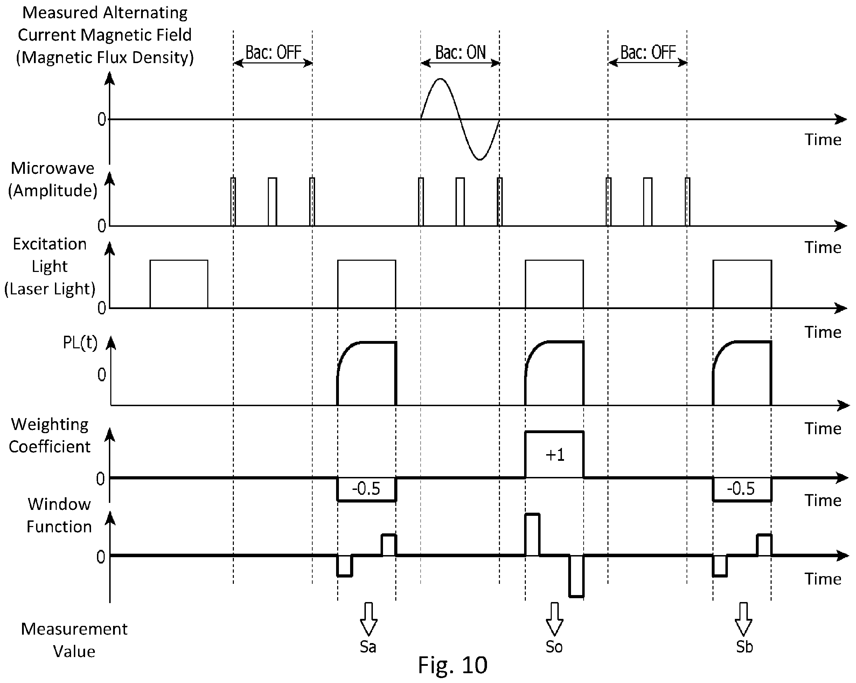

Fig. 9 is a block diagram that shows a configuration of a measurement device according to a second embodiment of the present invention. Fig. 10 is a diagram that shows an example of a fluorescence sensor signal and a window function.

In the second embodiment, the common mode rejection is not performed. The fluorescence sensor signal PL(t) is digitized by the analog/digital converter 26. The arithmetic part 42 applies the above-mentioned window function to the fluorescence sensor signal PL(t) and derives each of the measurement values (the preceding measurement value, the main measurement value, and the succeeding measurement value) based on the fluorescence sensor signal PL(t) to which the window function has been applied. Here, the window function is used to derive the difference in the integrated value of the fluorescence sensor signal PL(t) between the first period P1 in the first half and the second period P2 in the second half of the irradiation period of the excitation light. Further, in the same manner as the above-mentioned detection signal, the difference in the integrated value of the fluorescence sensor signal PL(t), to which the window function has been applied, is correlated with an intensity of the measured field. Therefore, the intensity of the measured field is derived from the difference in the integrated value of the fluorescence sensor signal PL(t), to which the window function has been applied, by specifying a correspondence relation between the difference in the integrated value and the intensity of the measured field by such as experiments in advance and using a calculation equation or a table that shows the correspondence relation.

Further, after the succeeding measurement value is obtained, the arithmetic part 42 derives the measurement value of the measured field based on the main measurement value, and the preceding measurement value and the succeeding measurement value immediately before and after the main measurement value.

Note that the other configurations and operations of the measurement device according to the second embodiment are the same as those explained in the first embodiment. Therefore, the explanations of the other configurations and operations of the measurement device according to the second embodiment will be omitted.

THIRD EMBODIMENT

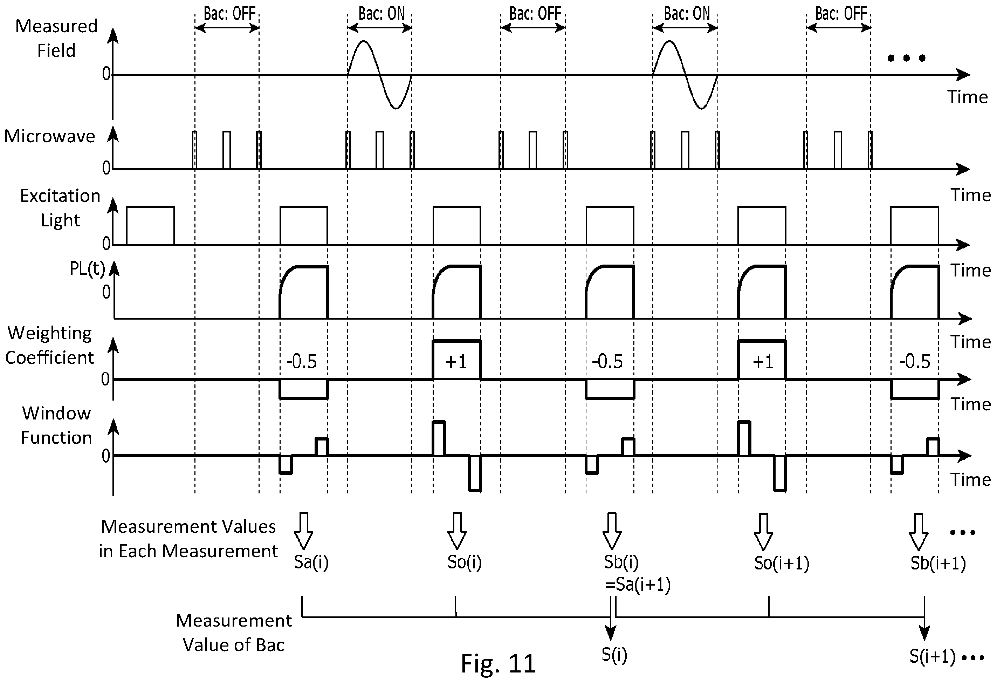

Fig. 11 is a diagram that explains continuous measurements of the measured field according to a third embodiment. In the third embodiment, as shown in, for instance, Fig. 11, (a) the measurement values which are obtained where the measured field is applied to the magnetic resonance member 1 and the measurement values which are obtained where the measured field is not applied to the magnetic resonance member 1 are alternately obtained (here, repeatedly obtained at a predetermined time interval), and (b) a succeeding measurement value $Sb(i)$ of (the ith measurement) is used as a preceding measurement value $Sa(i+1)$ for a next main measurement value $So(i+1)$ (that is, of the $(i+1)$th measurement) so as to continuously derive the measurement values $S(i)$, $S(i+1)$, and ... of the measured field. Note that the acquisitions (that is, the measurements) of each of the measurement values $Sa$, $Sb$, and $So$ are the same as those explained in the first embodiment or the second embodiment.

Therefore, since the measurement value which is obtained where the measured field is not applied to the magnetic resonance member 1 (for the ith measurement) is used as the succeeding measurement value Sb(i) and the preceding measurement value Sa(i+1), the measurement value is retained in a memory (not shown) at least until the (i+1) th measurement is completed.

Note that the other configurations and operations of the measurement device according to the third embodiment are the same as those explained in the first second embodiment or the second embodiment. Therefore, the explanations of the other configurations and operations of the measurement device according to the third embodiment will be omitted.

As mentioned above, according to the third embodiment, because the succeeding measurement value Sb(i) is used as the preceding measurement value Sa(i+1) for the next main measurement value So(i+1), a required period of time for continuously performing a plurality of continuous measurements is shortened. That is, the number of measurements per a predetermined time is increased. Thus, when the measurement values are averaged, the random noise in the measurement values can be reduced (in proportion to the square root of the number of measurements) and the measurement sensitivity is improved.

Note that various changes and modifications to the embodiments described above will be apparent to one having ordinally skill in the art. Such the changes and modifications may be made without departing from the spirit and scope of the subject matter and without diminishing the intended advantages. That is, it is intended that such the changes and modifications are included within the scope of the claims.

For instance, in the above embodiments, the magnetic field measurement is performed based on the optically detected magnetic resonance. However, for instance, a temperature measurement can also be performed in the same manner. It is also possible to perform a current measurement based on the magnetic field obtained by the magnetic field measurement.

Further, in the above embodiments, in separation of the reference light for the common mode rejection, the reference light for calculating the detection signal using the above-mentioned reference light sensor signal is branched from the excitation light. However, the reference light that is branched for the common mode rejection may also be used as the reference light for calculating the detection signal using the above-mentioned reference light sensor signal. Further, although the above-mentioned reference light sensor signals ref1 and ref2 are separately generated, it is also possible that one reference light sensor signal ref is generated and used as the above-mentioned reference light sensor signals ref1 and ref2.

Further, in the above embodiments, the CMR signal or the level variation component signal is used as the detection signal, however, a signal other than these signals (a signal being indicative of the measured field) may also be used as the detection signal.

Furthermore, in the above embodiments, the differential amplifier 25b may be provided in separation of the analog/digital converter 26 or may be built in the analog/digital converter 26.

In addition, in the above embodiments, the window function has the rectangular waveform (that is, a constant value in each of the periods P1 and P2). However, a waveform of another shape may also be adopted. In other words, the window function may have values that change in each of the periods P1 and P2.

INDUSTRIAL APPLICABILITY

The present invention can be applicable to, for instance, a measurement device that uses optically detected magnetic resonance.

**Claims**

1. A measurement device comprising:

   a magnetic resonance member in which an electron spin quantum state changes in response to a measured field and in which an electron spin quantum operation can be performed by using a microwave;
   a high frequency magnetic field generator that performs the electron spin quantum operation of the magnetic resonance member by using the microwave;
   a light emitting device that emits excitation light to irradiate the magnetic resonance member;
   a fluorescence light receiving device that receives fluorescence emitted by the magnetic resonance member in response to the excitation light and generates a fluorescence sensor signal corresponding to an intensity of the fluorescence; and
   an arithmetic processing device that derives a measurement value based on the fluorescence sensor signal or a detection signal that is obtained from the fluorescence sensor signal,
   wherein a measurement value, which is measured when the measured field is applied to the magnetic resonance member, is defined as a main measurement value,

a measurement value, which is measured when the measured field is not applied to the magnetic resonance member and before the main measurement value is measured, is defined as a preceding measurement value, a measurement value, which is measured when the measured field is not applied to the magnetic resonance member and after the main measurement value is measured, is defined as a succeeding measurement value, and

the arithmetic processing device respectively subtracts the preceding measurement value and the succeeding measurement value from the main measurement value at a predetermined ratio to derive the measurement value of the measured field.

2. A measurement method comprising:

performing an electron spin quantum operation with respect to a magnetic resonance member by using a microwave according to a predetermined measurement sequence and emitting excitation light to irradiate the magnetic resonance member, an electron spin quantum state being changed in response to a measured field and the electron spin quantum operation being performed by using the microwave in the magnetic resonance member;

receiving fluorescence emitted by the magnetic resonance member in response to the excitation light and generating a fluorescence sensor signal corresponding to an intensity of the fluorescence; and

deriving a measurement value based on the fluorescence sensor signal or a detection signal that is obtained from the fluorescence sensor signal,

wherein a measurement value, which is measured when the measured field is applied to the magnetic resonance member, is defined as a main measurement value,

a measurement value, which is measured when the measured field is not applied to the magnetic resonance member and before the main measurement value is measured, is defined as a preceding measurement value,

a measurement value, which is measured when the measured field is not applied to the magnetic resonance member and after the main measurement value is measured, is defined as a succeeding measurement value, and

the measurement value of the measured field is derived by respectively subtracting the preceding measurement value and the succeeding measurement value from the main measurement value at a predetermined ratio.

3. The measurement method according to claim 2, further comprising:

applying a predetermined window function to the fluorescence sensor signal or the detection signal; and deriving the measurement value based on the fluorescence sensor signal or the detection signal to which the window function has been applied,

wherein the window function is for deriving, as the measurement value, a difference in an integrated value of the fluorescence sensor signal or the detection signal between a first period in a first half and a second period in a second half of an irradiation period of the excitation light,

when measuring the preceding measurement value and the succeeding measurement value, the preceding measurement value and the succeeding measurement value are derived by respectively applying the window function multiplied by a weighting coefficient corresponding to the ratio, and

the measurement value of the measured field is derived from the main measurement value and the preceding measurement value and the succeeding measurement value as the preceding measurement value and the succeeding measurement value are substantially respectively subtracted from the main measurement value at the ratio.

4. The measurement method according to claim 2 or claim 3, further comprising:

performing, with respect to the fluorescence sensor signal, common mode rejection based on a reference light sensor signal that is generated by receiving reference light obtained by branching the excitation light, wherein the detection signal is generated based on the common mode rejection.

5. The measurement method according to claim 2,

wherein (a) the measurement value obtained by applying the measured field to the magnetic resonance member and the measurement value obtained by not applying the measured field to the magnetic resonance member are alternately obtained, and

(b) the measurement value of the measured field is continuously derived by using the succeeding measurement value as the preceding measurement value with respect to a next measurement of the main measurement value.

Excitation Light

ref2

ADC **27**

**22** **24**

Measured
Magnetic Field

**21** **23**

ref1

**10** **25**

**25a**

ref1*$\alpha_{init}$*$(2\gamma I_{laser} + 1)/\beta$

$\alpha_{init} * \gamma * I_{laser}^2$

**3** **2**

**1**

Static
Magnetic
Field

Fluore-
scence

**25b**

CMR_SIG

+Vs

**25c**

**26**

ADC

-Vs

**11** **13**

High Frequency
Power Source

PL

**31**

Arithmetic Processing Device

**41** **42** **43**

Measurement
Control Part

Arithmetic
Part

Storage
Device

Fig. 1

Fluorescence Sensor Signal
Level (V)

0

Light Emitting Device
Laser Output (W)

Fig. 2

Fig. 3

Fig. 4

Fig. 5

Fig. 6

Fig. 7

Start

Starting Measurement
Sequence

S11

Emitting Measurement Light
Detecting Fluorescence

S12

Deriving CMR Signal

S13

Deriving Measurement Values (Preceding, Main, and
Succeeding Measurement Values) by Applying Window
Function to CMR Signal

S14

End

Fig. 8

**Excitation Light**

Measured
Magnetic Field

Static
Magnetic
Field

Fluore-
scence

PL

A D C

High Frequency
Power Source

Arithmetic Processing Device

Measurement
Control Part

Arithmetic
Part

Storage
Device

Fig. 9

Fig. 10

Fig. 11

## INTERNATIONAL SEARCH REPORT

| International application No. |
|---|
| **PCT/JP2023/014755** |

### A. CLASSIFICATION OF SUBJECT MATTER

***G01N 24/00***(2006.01)i; ***G01R 33/20***(2006.01)i; ***G01R 33/26***(2006.01)i
FI:   G01N24/00 P; G01R33/20; G01R33/26

According to International Patent Classification (IPC) or to both national classification and IPC

### B. FIELDS SEARCHED

Minimum documentation searched (classification system followed by classification symbols)

G01N24/00-G01N24/14, G01R33/00-G01R33/64, A61B5/055

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JST7580/ JSTChina (JDreamIII), Science Direct, IEEE Xplore, Wiley Online Library, nature.com, SCIENCE, Scitation
, SPIE Digital Library, APS Journals, KAKEN

### C. DOCUMENTS CONSIDERED TO BE RELEVANT

| Category* | Citation of document, with indication, where appropriate, of the relevant passages | Relevant to claim No. |
|---|---|---|
| A | JP 2018-136316 A (NISSIN ELECTRIC CO LTD) 30 August 2018 (2018-08-30) paragraphs [0102]-[0111] | 1-5 |
| A | WO 2021/119589 A1 (SONERA MAGNETICS, INC.) 17 June 2021 (2021-06-17) | 1-5 |
| A | JP 2020-063960 A (TOKYO INSTITUTE OF TECHNOLOGY) 23 April 2020 (2020-04-23) | 1-5 |
| A | JP 2022-036541 A (YAZAKI CORP) 08 March 2022 (2022-03-08) | 1-5 |
| A | WO 2021/200144 A1 (TOKYO INSTITUTE OF TECHNOLOGY) 07 October 2021 (2021-10-07) | 1-5 |
| A | JP 2018-040610 A (SEIKO EPSON CORP) 15 March 2018 (2018-03-15) | 1-5 |
| A | JP 2020-514709 A (QUANTUM DIAMOND TECHNOLOGIES INC) 21 May 2020 (2020-05-21) | 1-5 |

☑ Further documents are listed in the continuation of Box C.     ☑ See patent family annex.

| | |
|---|---|
| *  Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **24 May 2023** | **06 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/014755**

### C. DOCUMENTS CONSIDERED TO BE RELEVANT

| Category* | Citation of document, with indication, where appropriate, of the relevant passages | Relevant to claim No. |
|---|---|---|
| T | Diamond-Based Nanoscale Quantum Relaxometry for Sensing Free Radical Production in Cells. Small. 28 September 2022, vol. 18, 2105750, doi: 10.1002/smll.202105750<br>  fig. 1-5, S1-S16 | 1-5 |
| A | Quantitative study of the response a single NV defect in diamond to magnetic noise. PHYSICAL REVIEW B. 15 June 2021, vol. 103, 235418, doi: 10.1103/PhysRevB.103.235418<br>  fig. 1-3 | 1-5 |
| P, A | JP 2023-022435 A (SUMIDA CORP) 15 February 2023 (2023-02-15) | 1-5 |

Form PCT/ISA/210 (second sheet) (January 2015)

## INTERNATIONAL SEARCH REPORT
### Information on patent family members

International application No.

**PCT/JP2023/014755**

| Patent document cited in search report | | | Publication date (day/month/year) | Patent family member(s) | | | Publication date (day/month/year) |
|---|---|---|---|---|---|---|---|
| JP | 2018-136316 | A | 30 August 2018 | (Family: none) | | | |
| WO | 2021/119589 | A1 | 17 June 2021 | JP | 2023-506737 | A | |
| | | | | US | 2021/0181132 | A1 | |
| | | | | EP | 4055402 | A1 | |
| | | | | AU | 2020403258 | A1 | |
| | | | | CA | 3164442 | A1 | |
| | | | | CN | 115176167 | A | |
| JP | 2020-063960 | A | 23 April 2020 | US | 2022/0050153 | A1 | |
| JP | 2022-036541 | A | 08 March 2022 | (Family: none) | | | |
| WO | 2021/200144 | A1 | 07 October 2021 | (Family: none) | | | |
| JP | 2018-040610 | A | 15 March 2018 | (Family: none) | | | |
| JP | 2020-514709 | A | 21 May 2020 | US | 2019/0331674 | A1 | |
| | | | | WO | 2018/119367 | A1 | |
| | | | | EP | 3559668 | A1 | |
| | | | | CA | 3046849 | A1 | |
| JP | 2023-022435 | A | 15 February 2023 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019138772 A